# EUROPÄISCHE PATENTANMELDUNG

(11) **EP 0 718 614 A2**
(43) Veröffentlichungstag der Anmeldung: **26.06.1996**
(21) Anmeldenummer: 95118175.9
(22) Anmeldetag: 18.11.1995
(51) Int. Cl.: G01M 17/00, G01M 15/00

(54) **Vorrichtung zur Durchführung eines Fahrzeugtests oder zur Auswertung von Störungen und/oder Ausfällen von Fahrzeugfunktionen**

(30) Priorität: 24.12.1994 DE 4446512
(71) Anmelder: Alcatel SEL Aktiengesellschaft, D-70435 Stuttgart (DE); ALCATEL N.V., NL-2288 BH Rijswijk (NL)
(72) Erfinder: Heil, Helge-Ludwig, D-65375 Oestrich-Winkel 2 (DE)
(74) Vertreter: Knecht, Ulrich Karl

(57) **Zusammenfassung**

Durchführung eines Fahrzeugtests mit anschließender Auswertung von Fahrzeugfehlern unabhängig von Ort und Zeit und während eines Fahrbetriebs.

Verwendung eines herkömmlichen Mobilfunktelefons zum Senden von Störungsmeldungen oder Ausfallmeldungen an eine weitere Vorrichtung, sowie zum Empfangen von Regelungsinformation zur Behebung von Störungen und zum Empfangen und Anzeigen von Warnungsnachrichten oder Information über bestehende Störungen oder Ausfälle, die von der weiteren Vorrichtung gesendet werden. Die Übertragung erfolgt über ein Mobilfunknetz.

## Beschreibung

Die Erfindung betrifft eine Vorrichtung zur Durchführung eines Fahrzeugtests und zur Behandlung von Fahrzeugfehlern. Desweiteren betrifft die Erfindung eine Vorrichtung zur Auswertung von Meldungen über Fahrzeugfehler.

Aus dem Stand der Technik sind Fahrzeugkontrollsysteme bekannt, insbesondere aus dem Bereich des Rennsports, z.B. Formel 1, welche eine permanente Kontrolle der Fahrzeugfunktionen während des Fahrens vornehmen. Während eines Rennens wird dabei mittels Funk von den Sensoren ein Signal zu einem zentralen Auswerte-PC gesendet, in dem dann wiederum das Fahrverhalten, die Fahrzeugeigenschaften und die Funktionstüchtigkeit der Fahrzeugteile überprüft wird.

Desweiteren sind aus dem Stand der Technik Systeme bekannt, die innerhalb einer Werkstatt einen sogenannten Fahrzeugcheck vornehmen. Hierbei wird ein spezielles System mittels Kabel an ein Fahrzeug angeschlossen und ein Prüfsystem prüft unterschiedliche Fahrzeugfunktionen. Bei Verwendung dieses Systems muß ein Fahrzeughalter mit seinem Fahrzeug in eine Werkstatt fahren. Dies wiederum bedeutet, daß in dieser Zeit das Fahrzeug nicht zur privaten Nutzung zur Verfügung steht, und daß diverse Wartezeiten auftreten. Desweiteren läßt sich nicht ermitteln, wie das Fahrzeugverhalten im Hochlastfahrbetrieb, z.B. auf der Autobahn bei 180 km/h ist.

Demgemäß ist die Aufgabe der vorliegenden Erfindung, eine Vorrichtung vorzusehen, die einen Fahrzeugtest oder eine Behandlung von Fahrzeugfehlern jederzeit, auch während eines Fahrbetriebs, ermöglicht und die die vorangestellten Nachteile vermeidet.

Die Aufgabe wird erfindungsgemäß gelöst durch die Lehre des Patentanspruchs 1 und durch die Lehre des Patentantspruchs 2.

Im folgenden wird die Erfindung anhand der Figuren näher erläutert. Folgende Figuren zeigen:
- Fig. 1: Schematische Darstellung der Erfindung nach Patentanspruch 1,
- Fig. 2: schematische Darstellung der Erfindung nach Patentanspruch 2.

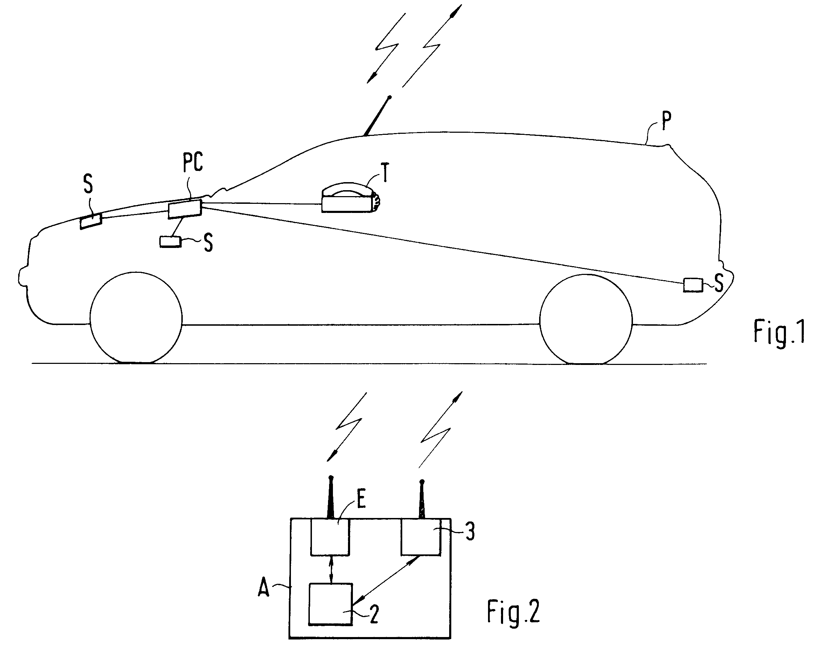

Im folgenden wird anhand von Fig. 1 die Vorrichtung gemäß Patentanspruch 1 näher erläutert.

In einem Fahrzeug P werden Sensoren S zur Feststellung von Störungen von Fahrzeugfunktionen oder Ausfällen von Fahrzeugteilen angebracht. Die Sensoren S stellen während eines Fahrbetriebs, aber auch während eines Ruhezustands fest, ob sich an Fahrzeugteilen oder bei der Ausführung von Fahrzeugfunktionen Störungen oder Ausfälle ergeben. Die so ermittelten Daten werden als Störungsmeldungen oder Ausfallmeldungen von Mitteln PC zum Aufbereiten oder Auswerten ausgewertet. Desweiteren besteht die Vorrichtung aus einem Mobilfunkteil T zum Übermitteln der aufbereiteten oder ausgewerteten Störungsmeldungen oder Ausfallmeldungen. Dieses Mobilfunkteil T, beispielsweise ein Mobilfunktelefon, sendet über ein Mobilfunknetz die Störungsmeldungen oder Ausfallmeldungen an eine Auswertevorrichtung A. Das Mobilfunkteil T kann aber andererseits auch Regelungsinformationen oder Nachrichten zur Behebung von Störungen oder Ausfällen empfangen. Desweiteren können über dieses Mobilfunkteil T Informationen über vorliegende Fahrzeugfehler empfangen und zur Anzeige gebracht werden.

Im folgenden wird anhand von Fig. 2 die Vorrichtung zur Auswertung von Meldungen über Fahrzeugfehler näher erläutert.

Die Vorrichtung A zur Auswertung von Meldungen besitzt Empfangsmittel E zum Empfang der über ein Mobilfunknetz übermittelten Störungsmeldungen von Fahrzeugfunktionen oder Ausfallmeldungen von Fahrzeugteilen. Desweiteren besteht die Vorrichtung A zur Auswertung, aus Mitteln 2 zum Auswerten der Störungsmeldungen oder Ausfallmeldungen. Das Mittel 2 zum Auswerten kann beispielsweise ein Mikroprozessor mit einem Speicher sein. Ein weiteres Mittel, ein Sendemittel 3 zum Senden von Regelungsinformationen zur Behebung der Störungen oder der Ausfälle oder zum Senden von Nachrichten zur Warnung oder zur Information über bestehende Störungen oder Ausfälle befindet sich ebenfalls in der Vorrichtung zur Auswertung. Über dieses Mittel 3 werden die vorab genannten Informationen oder Nachrichten zu dem Fahrzeug gesendet.

Im folgenden wird gezeigt (ohne Zeichnung), wie die Vorrichtung zur Durchführung von Fahrzeugtests und die Vorrichtung zur Auswertung von Meldungen über Fahrzeugfehler miteinander kommunizieren und wie sie zusammenarbeiten. Ein Fahrzeug, beispielsweise ein Pkw, ist mit der Vorrichtung zur Durchführung eines Fahrzeugtests und zur Behandlung von Fahrzeugfehlern ausgestattet. Sensoren S zur Feststellung von Störungen oder Ausfällen sind an beliebigen Stellen im Fahrzeug angebracht. Die Anzahl der Sensoren kann hier zwischen einem und mehreren Sensoren variieren, entsprechend der gewünschten Überprüfungsmöglichkeiten. Nun ist z.B. der Fall gegeben, daß der Pkw zu seiner regelmäßigen Inspektion in eine Werkstatt gebracht werden müßte. Der Besitzer des Pkw's hat aber beispielsweise keine Zeit, einen Test in einer Werkstatt durchführen zu lassen; oder als eine weitere Anwendung dieser Vorrichtung könnte auch der Fall gegeben sein, daß dieser Test dann ausgeführt werden sollte, wenn der Pkw in Betrieb ist, also fährt. Dies kann vorteilhaft sein, da dabei z.B. das Temperaturverhalten, das Fahrverhalten und somit auch die Funktion der Teile während dieses Fahrverhaltens überprüft werden.

Der Benutzer des Pkw's wünscht nun, einen Fahrzeugtest an seinem Pkw durchzuführen und stellt mittels des Mobilfunkteils T eine Verbindung zur einer Werkstatt her. Dieses Funkteil kann vorzugsweise ein Mobilfunktelefon sein, über das eine Verbindung zu einem weiteren Mobilfunktelefon oder einem Datenverarbeitungsgerät mit Telefonfunktion, in einer Werkstatt hergestellt wird. In einem weiteren Schritt wird nun angezeigt, daß die von den Sensoren aufgenommenen Signale an eine Werkstatt gesendet werden sollen. Eine weitere Ausgestaltung dieses Szenarios kann es sein, daß die Sensorsignale bereits innerhalb des Fahrzeugs mittels eines Mittels zum Aufbereiten oder Auswerten von über die Sensoren festgestellten Störungsmeldungen oder Ausfallmeldungen aufbereitet werden. Demnach werden die bereits aufbereiteten Daten an die Werkstatt gesendet.

In der Werkstatt befindet sich die Vorrichtung A zur Auswertung von Meldungen über Fahrzeugfehler. Diese Vorrichtung ist in der Lage, die Signale, die über das Mobilfunknetz von einem Mobilfunkteilnehmer aus dem Pkw ausgesendet werden, zu empfangen. Hierbei gibt es die beiden Möglichkeiten, entweder die Signale, die die Sensoren S aufgenommen haben direkt zu empfangen, oder bereits aufbereitete oder ausgewertete Signale, die über das Mittel PC zum Aufbereiten und Auswerten von über Sensoren festgestellten Störungsmeldungen oder Ausfallmeldungen, aufzunehmen. In der Werkstatt befinden sich innerhalb dieser Vorrichtung weiterhin Mittel 2 zum Auswerten der Störungsmeldungen oder der Ausfallmeldungen. Die ausgewerteten Störungsmeldungen oder Ausfallmeldungen werden beispielsweise mittels eines bekannten Diagnoseverfahrens daraufhin überprüft, ob eine direkte Behebung möglich ist, oder ob es nötig ist, daß der Pkw sich in die Werkstatt begibt.

Die Vorrichtung besitzt weiterhin Sendemittel 3 zum Senden von Informationen über ein Mobilfunknetz. Für den Fall, daß eine direkte Behebung der Störung oder der Ausfälle möglich ist, kann nun zu der weiteren Vorrichtung zur Durchführung eines Fahrzeugtests und zur Behandlung von Fahrzeugfehlern ein Signal gesendet werden, so daß der Ausfall oder die Störung direkt behoben wird. Desweiteren ist es möglich, lediglich eine Nachricht zur Warnung des Besitzers des Pkw's zu senden, um ihm anzuzeigen, daß er sich in eine Werkstatt begeben muß oder um dem Fahrzeuginhaber anzuzueigen, oder eine Information darüber zu geben, daß Störungen und Ausfälle bereits existieren.

Eine weitere Ausgestaltung der Erfindung kann es sein, daß sich in dem Fahrzeug Sensoren befinden, die im Falle eines Unfalls Signale über die Mittel PC zum Aufbereiten oder Auswerten automatisch an, z.B. eine Polizeistation weiterleiten.

## Patentansprüche

1. Vorrichtung zur Durchführung eines Fahrzeugtests und zur Behandlung von Fahrzeugfehlern mit
- Sensoren (S) zur Feststellung von Störungen von Fahrzeugfunktionen oder Ausfällen von Fahrzeugteilen,
- Mitteln (PC) zum Aufbereiten oder Auswerten von über die Sensoren festgestellten Störungsmeldungen oder Ausfallmeldungen und
- einem Mobilfunkteil (T) zum Übermitteln der aufbereiteten oder ausgewerteten Störungsmeldungen oder Ausfallmeldungen über ein Mobilfunknetz an eine Auswertevorrichtung, und zum Empfangen von Regelungsinformationen oder Nachrichten zur Behebung von Störungen, Ausfällen oder zur Information über vorliegende Fahrzeugfehler.

2. Vorrichtung (A) zur Auswertung von Meldungen über Fahrzeugfehler mit
- Empfangsmitteln (E) zum Empfang der über ein Mobilfunknetz übermittelten Störungsmeldungen von Fahrzeugfunktionen oder Ausfallmeldungen von Fahrzeugteilen
- Mitteln (2) zum Auswerten der Störungsmeldungen oder Ausfallmeldungen, und
- Sendemitteln (3) zum Senden von Regelungsinformationen zur Behebung der Störungen oder der Ausfälle, oder zum Senden von Nachrichten zur Warnung oder zur Information über bestehende Störungen oder Ausfälle.

3. Vorrichtung nach Anspruch 1, bei der der Fahrzeugtest automatisch in regelmäßigen Abständen automatisch, auch während eines Fahrbetriebs wiederholt wird,

4. Vorrichtung nach einem der Ansprüche 1 oder 3, bei der im Falle eines Unfalls automatisch eine Unfallmeldung über das Mobilfunknetz übermittelt wird.

5. Vorrichtung nach Anspruch 2, mit der ein Fahrzeugtest über eine Vorrichtung nach Anspruch 1 in einem Fahrzeug automatisch ausgelöst werden kann.

6. Vorrichtung nach Anspruch 2, bei der das Sendemittel ein mobiles Telefon oder ein Datenverarbeitungsgerät mit Telefonfunktion ist.
